(19) Europäisches Patentamt
European Patent Office
Office européen des brevets

(11) **EP 1 682 911 B1**

(12) **EUROPÄISCHE PATENTSCHRIFT**

(45) Veröffentlichungstag und Bekanntmachung des Hinweises auf die Patenterteilung:
**21.11.2007 Patentblatt 2007/47**

(51) Int Cl.:
*G01R 31/333* [(2006.01)]          *G01R 31/327* [(2006.01)]
*H01H 1/00* [(2006.01)]          *H01H 9/00* [(2006.01)]

(21) Anmeldenummer: **04765154.2**

(22) Anmeldetag: **14.09.2004**

(86) Internationale Anmeldenummer:
**PCT/EP2004/010237**

(87) Internationale Veröffentlichungsnummer:
**WO 2005/052616 (09.06.2005 Gazette 2005/23)**

(54) **VERFAHREN ZUR ÜBERWACHUNG DES KONTAKTABBRANDES BEI STUFENSCHALTERN**

METHOD FOR MONITORING CONTACT CONSUMPTION IN MULTIPLE CONTACT SWITCHES

PROCEDE DE SURVEILLANCE DE L'USURE DES CONTACTS DE COMMUTATEURS A GRADINS

(84) Benannte Vertragsstaaten:
**AT BE BG CH CY CZ DE DK EE ES FI FR GB GR HU IE IT LI LU MC NL PL PT RO SE SI SK TR**

(30) Priorität: **11.11.2003 DE 10352580**

(43) Veröffentlichungstag der Anmeldung:
**26.07.2006 Patentblatt 2006/30**

(73) Patentinhaber: **Maschinenfabrik Reinhausen GmbH**
**93059 Regensburg (DE)**

(72) Erfinder:
• **DOHNAL, Dieter**
  **93138 Lappersdorf (DE)**
• **FROTSCHER, Rainer**
  **93128 Regenstauf (DE)**

(56) Entgegenhaltungen:
**EP-A- 0 948 006          DE-C- 10 003 918**
**US-A- 3 735 243**

**Beschreibung**

Die Erfindung betrifft ein Verfahren zur Überwachung des Kontaktabbrandes bei Stufenschaltern mit Überschaltreaktanz.

Ein Verfahren zur Überwachung des Kontaktabbrandes bei Stufenschaltern ist aus der DE 100 03 918 C1 bereits bekannt. Dabei werden bei jeder Lastumschaltung, d. h. jeder Betätigung des Stufenschalters, aus dem gemessenen Wert des Laststromes und der jeweiligen Nenn-Stufenspannung die Schaltströme der jeweils abschaltenden Kontakte und aus diesen die jeweiligen Abbrandraten ermittelt. Nachfolgend werden dann aus diesen Abbrandraten die kumulierten Volumenabbrände der Schaltkontakte und Widerstandskontakte des Lastumschalters des Stufenschalters ermittelt und mit vorab festgelegten Grenzwerten verglichen.

Das bekannte Verfahren ist jedoch prinzipiell nur bei solchen Stufenschaltern anwendbar, bei denen ein zweiarmiger Wähler zunächst leistungslos eine neue Wicklungsanzapfung, auf die umgeschaltet werden soll, vorwählt und danach ein separater Lastumschalter den Laststrom zwischen der gerade stromführenden Anzapfung des einen Wählerarmes und neuen Anzapfung des anderen Wählerarmes umschaltet. Für Stufenschalter des Lastwählertyps jedoch, bei denen durch sich bewegende Schaltkontakte die Wähl- als auch die Schaltfunktion in einem Schritt ausgeführt wird, die mithin also keinen separaten Lastumschalter besitzen, ist das bekannte Verfahren nicht geeignet. Es ist ebenfalls nicht geeignet für Stufenschalter mit einer Überschaltreaktanz, d. h. Stufenschaltern, die nach dem Prinzip des Reaktorschalters arbeiten.

Aufgabe der Erfindung ist es, ein gattungsgemäßes Verfahren für einen Stufenschalter mit Überschaltreaktanz anzugeben.

Diese Aufgabe wird durch ein Verfahren mit den Merkmalen des Patentanspruches 1 gelöst.

Nachfolgend sollen zunächst die allgemeine erfinderische Idee und die gerätespezifischen Hintergründe des erfindungsgemäßen Verfahrens erläutert werden.

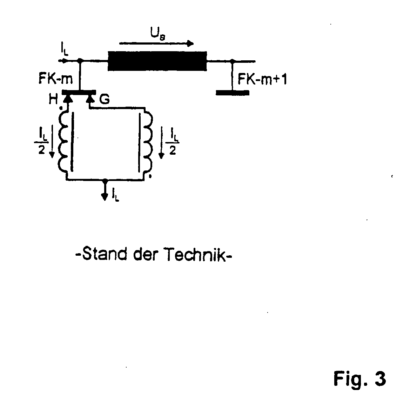

Figur 3 zeigt einen aus dem Stand der Technik bekannten Stufenschalter mit Überschaltreaktanz (SVR). Stufenschalter dieser Bauart eines Lastwählers finden zumeist in regelbaren Verteiltransformatoren in den USA als sogenannte "step voltage regulators" Verwendung. Üblich ist ein Regelbereich von $\pm 10\%$ in $\pm 16$ Stufen zu je ⅝ %. Anstelle der Überschaltwiderstände wird hier eine Überschaltreaktanz eingesetzt. Bei einer Umschaltung von der Anzapfung m auf m + 1 verlässt hierbei der bewegliche Schaltkontakt SK - G den feststehenden Stufenkontakt FK - m, wobei der halbe Laststrom auf den in der Figur linken Zweig kommutiert wird und durch den dabei entstehenden Lichtbogenabbrand am beweglichen Schaltkontakt SK - G sowie an der in der Figur rechten Flanke des Stufenkontaktes FK - m entsteht. Der Schaltkontakt SK - G schaltet auf den neuen Stufenkontakt FK - m + 1 auf und erreicht damit die sogenannte "bridging position", die bei Lastwählern dieser Bauart eine stabile Betriebsstellung ist. Der durch die Stufenspannung $U_S$ getriebene Kreisstrom erzeugt in der Überschaltreaktanz keine Verluste, da die beiden gleich großen Wicklungsteile gegensinnig gewickelt sind und sich dadurch die Induktionen im Eisenkern der Reaktanz aufheben. Im weiteren Schaltablauf in Richtung m + 1 verlässt nun der Schaltkontakt SK - H den festen Stufenkontakt FK - m und schaltet dabei den Kreisstrom und den halben Laststrom ab; es entsteht Abbrand am Schaltkontakt SK - H und wiederum an der in der Figur rechten Flanke des Stufenkontaktes FK - m. Mit dem Aufschalten des Schaltkontaktes SK - H auf den Stufenkontakt FK - m + 1 ist wieder eine "non-bridging position" erreicht und die Umschaltung von m auf m + 1 vollzogen. "Bridging position" und "non-bridging position" wechseln sich also beim fortgesetzten Umschalten in einer Richtung jeweils ab. Durch die Tatsache, dass, wie beschrieben, die "bridging position", also die Mittelstellung zwischen zwei Stufen, eine stabile Betriebsstellung ist, lassen sich z. B. mit einer 9-stufigen Regelwicklung und vorgeschaltetem Wender 33 unterschiedliche Ausgangsspannungen einstellen. Die Stufung der Ausgangsspannung beträgt dabei $U_S/2$.

Bei dieser Art von Stufenschaltern mit Überschaltreaktanz gibt es immer nur einen abschaltenden Schaltkontakt, also SK - G oder SK - H, der je nach Schaltrichtung mit unterschiedlichen Strömen beaufschlagt wird.

Die symmetrisch zweigeteilte Überschaltreaktanz ist so dimensioniert, dass der Kreisstrom in der "bridging position" typischerweise 35% oder 50% vom Betrag des Laststromes $I_L$ beträgt (pa = 35% bzw. 50%). Dabei wird der Kreisstrom als rein induktiv angesehen. Aber auch der Laststrom $I_L$ kann eine Phasenverschiebung zur Stufenspannung $U_S$ aufweisen, was durch den Phasenwinkel *cos* φ ausgedrückt wird. Für Versorgungsnetze typisch ist ein cos φ von 0,8. Diese Größe lässt sich auch als sog. *power factor "pf"* (in USA üblich) in Prozent ausdrücken, z. B.: pf = 80%.

Bei rein induktivem $I_L$ ist pf = 0%, ein Wert, der bei worst case-Betrachtungen Berücksichtigung findet. Damit ergeben sich die Schaltströme als komplexe Größen mit Real- und Imaginärteil.

Weiterhin ergeben sich folgende Zusammenhänge:

Kreisstrom:

$$I_C = I_L \cdot \frac{pa}{100}$$

ohmsche Komponente:

$$R = \frac{pf}{100}$$

(fortgesetzt)

induktive Komponente:
$$X = \sqrt{1 - R^2}$$

Damit errechnen sich die Schaltströme schließlich zu:

<center>non-bridging $\Rightarrow$ bridging      bridging $\Rightarrow$ non-bridging</center>

Richtung $n \Rightarrow n+1$:
$$I_{SK} = \frac{I_L}{2} \qquad\qquad I_{SK} = \frac{I_L}{2} \cdot (R - jX) - jI_C$$

Richtung $n+1 \Rightarrow n$:
$$I_{SK} = \frac{I_L}{2} \qquad\qquad I_{SK} = \frac{I_L}{2} \cdot (R - jX) + jI_C$$

Nach Berechnung dieser Schaltströme lässt sich dann der Abbrand an den festen und den beweglichen Kontakten ermitteln.

Aus den Schaltströmen wird dabei eine Abbrandrate $A_{SK}$ des Schaltkontaktes sowie eine Abbrandrate $A_{FK}$ des jeweils abschaltenden Festkontaktes nach den allgemeinen Beziehungen

$$A_{SK} = a_{SK} \cdot I_{SK}{}^b \cdot s_{SK} \quad \text{bzw.}$$

$$A_{FK} = a_{FK} \cdot I_{SK}{}^b \cdot s_{FK}$$

ermittelt. Dabei sind $a_{SK}$ und $a_{FK}$ schaltertyp- und kontaktspezifische Abbrandparameter, der Wert b stellt einen vom eingesetzten Kontaktmaterial abhängigen Parameter in der Größenordnung von 1,1...1,9 dar. In vielen Fällen ist es noch sinnvoll, einen Sicherheitszuschlag, der vorteilhafterweise jeweils 12 % betragen kann, hinzuzurechnen. Die Parameter $s_{SK}$ bzw. $s_{FK}$, besitzen dann einen Wert größer als 1. Dieser Teil des Verfahrens ist an sich bereits aus der oben zitierten DE 100 03 918 C1 bekannt. Die auf diese Weise ermittelten unterschiedlichen Abbrandraten $A_{SK}$ sowie $A_{FK}$ werden zu den in den vorhergehenden Schaltungen kumulierten Gesamtabbränden $GA_m$ der jeweiligen Kontakte hinzuaddiert.

Beim erfindungsgemäßen Verfahren wird demnach für alle im Stufenschalter vorhandenen Abbrandkontakte - sowohl fest als auch beweglich - jeweils ein Wert für den Gesamtabbrand $GA_m$ ermittelt. Diese Werte werden jeweils nichtflüchtig gespeichert.

Nach jeder Stufenschaltung werden die auf die erläuterte Weise berechneten und gespeicherten Werte für die kumulierten Gesamtabbränden $GA_m$ aller Kontakte jeweils mit vorgegebenen zulässigen Grenzwerten verglichen. Wird ein Grenzwert im Ergebnis dieses Vergleiches erreicht oder überschritten, wird z. B. eine Warnmeldung generiert, etwa bei 90 % des erreichten Grenzwertes, ebenso kann aber auch der Stufenschalter ganz blockiert werden, wenn 100 % des vorab festgelegten Grenzwertes des Gesamtabbrandes erreicht sind.

Die Erfindung soll nachfolgend beispielhaft noch näher erläutert werden.

Figuren 1a bis 1d      zeigen den Ablaufplan eines erfindungsgemäßen Verfahrens

Figur 2      zeigt eine Zuordnungtabelle zur Durchführung dieses Verfahrens

Figur 3      zeigt die prinzipielle Schaltung eines Stufenschalters mit Überschaltreaktanz nach dem Stand der Technik, der weiter oben bereits erläutert wurde.

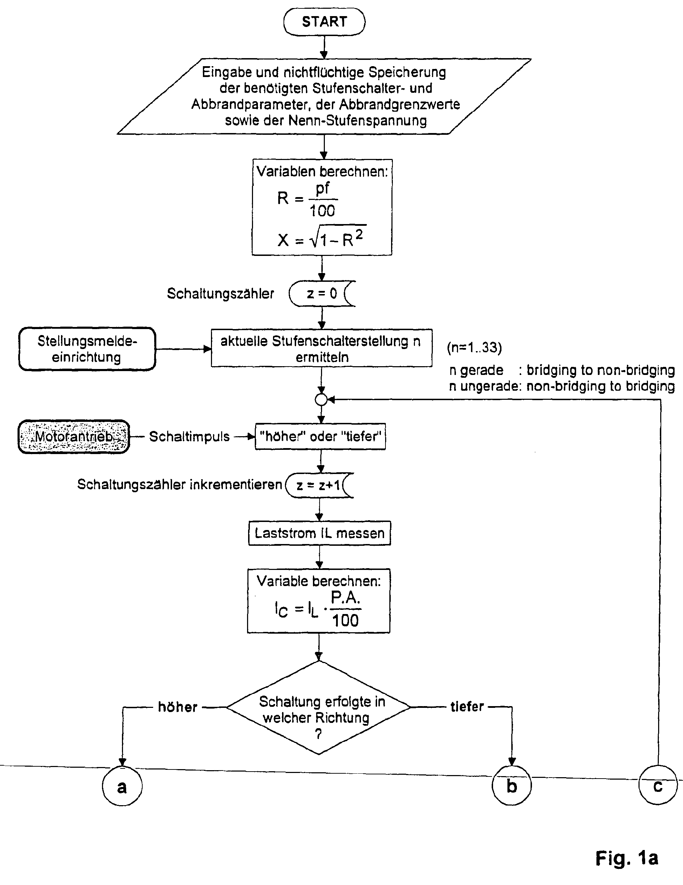

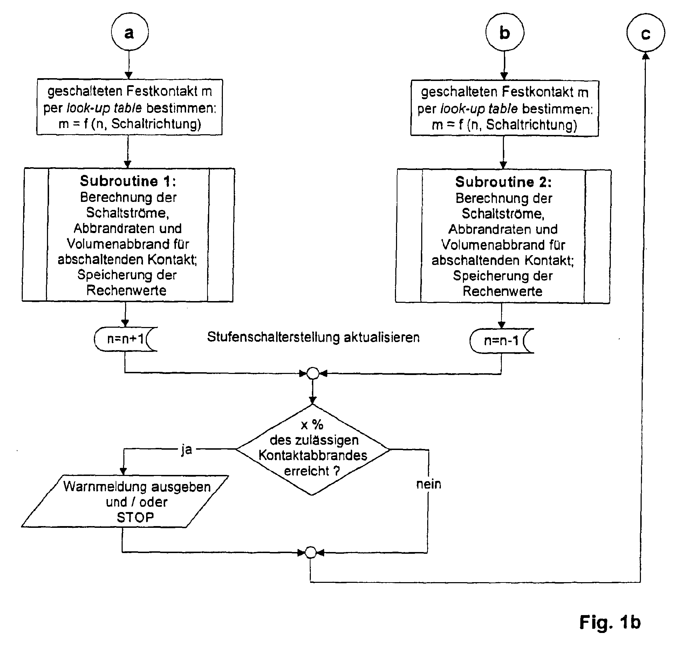

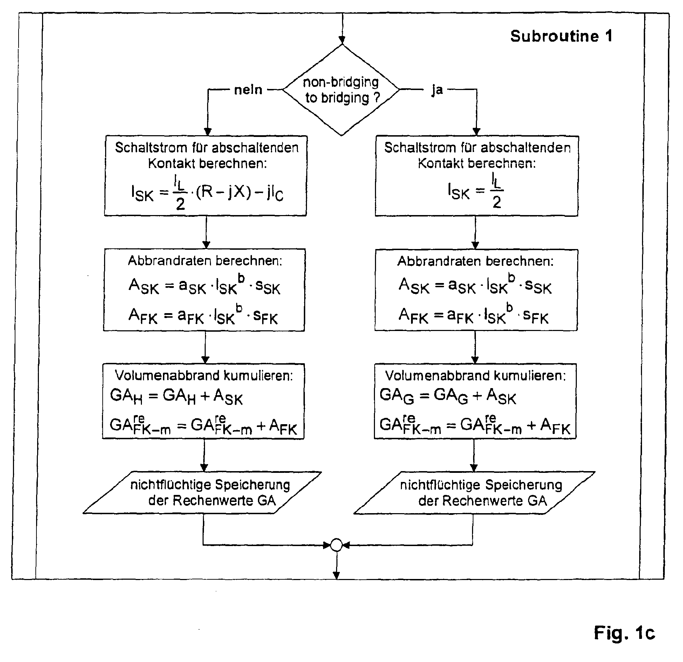

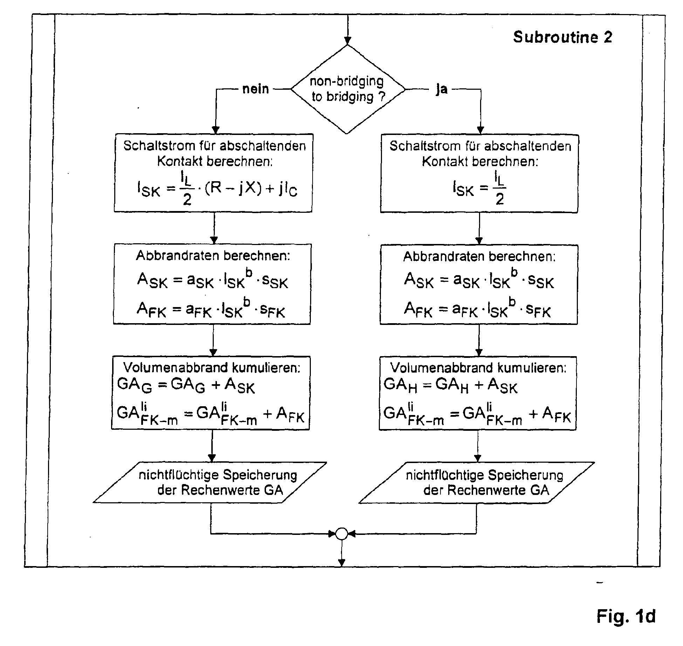

Anzumerken ist, dass die Figuren 1a bis 1d zusammengehören; in ihnen ist ein einziges erfindungsgemäßes Verfahren dargestellt. Lediglich aus Platzgründen musste dieses Verfahren auf getrennten Figurenblättern dargestellt werden. Die Einzelheiten der in Figur 1 b als "Subroutine" 1 bzw. 2 bezeichneten Verfahrensabläufe ist in den Figurenblättern 1c bzw. 1d detailliert dargestellt.

Beim erfindungsgemäßen Verfahren zur Überwachung des Kontaktabbrandes laufen nacheinander die folgenden Verfahrensschritte ab:

- Permanentes Speichern der Werte für die Nenn-Stufenspannung ($U_S$) jeder möglichen Schaltung, d. h. Stufe, der Grenzwerte für den zulässigen Kontaktabbrand des Schaltkontaktes sowie der Widerstandskontakte sowie der stufenschalterspezifischen Kenngrößen $a_{SK}$, $a_{FK}$, b, $s_{SK}$ und $s_{FK}$

- Berechnung der ohmschen Komponente R sowie der induktiven Komponente X der Überschaltreaktanz
- Ermittlung der aktuellen Stellung n des Stufenschalters
- Messung des Laststromes ($I_L$) bei jeder Umschaltung, d. h. Betätigung des Stufenschalters
- Berechnung des Kreisstromes $I_C$ als Teilbetrag des Laststromes $I_L$
- Ermittlung der Schaltrichtung "höher" oder "tiefer" der jeweiligen Umschaltung
- schaltrichtungsabhängige Ermittlung des geschalteten, abbrandbehafteten Festkontaktes
- Ermittlung, ob von einer nicht-brückenden auf eine brückende Position umgeschaltet wird oder nicht
- Berechnung des Schaltstromes der abschaltenden Kontakte jeweils mittels der Beziehungen

$$I_{SK} = \frac{I_L}{2}$$

für eine Schaltung von nicht-brückend nach brückend und

$$I_{SK} = \frac{I_L}{2} \cdot (R - jX) - jI_C \quad bzw. \quad I_{SK} = \frac{I_L}{2} \cdot (R - jX) + jI_C$$

im jeweils anderen Fall
- schaltrichtungsabhängige Berechnung der jeweiligen Abbrandraten des Schaltkontaktes ($A_{SK}$) und des abschaltenden Festkontaktes ($A_{FK}$) nach der Beziehung

$$A_{SK} = a_{SK} \cdot I_{SK}^{\ b} \cdot s_{SK}$$

$$A_{FK} = a_{FK} \cdot I_{SK}^{\ b} \cdot s_{FK}$$

- Aufsummierung der jeweiligen Abbrandraten ($A_{SK}$, $A_{FK}$) zum jeweiligen Gesamtvolumenabbrand ($GA_H$, $GA_G$, $GA^{re}_{FK-m}$, $GA^{li}_{FK-m}$), nichtflüchtige Speicherung aller aufsummierten Gesamtvolumenabbrände und Vergleich dieser Werte mit den entsprechenden permanent gespeicherten Grenzwerten
- Generierung von Meldungen beim Überschreiten der jeweiligen Grenzwerte oder prozentualer Grenzen davon.

Die einzelnen Beziehungen, nach denen erforderliche Verfahrensgrößen ermittelt werden, wurden bereits weiter oben ausführlich dargestellt. Nach der Eingabe und nichtflüchtigen Speicherung der benötigten Stufenschalter- und Abbrandparameter, der Abbrandgrenzwerte sowie der Nenn-Stufenspannung wird also zunächst eine Ermittlung der Variablen R und X auf die beschriebene Weise vorgenommen, wobei R, wie erläutert, die ohmsche Komponente darstellt und X die induktive Komponente ist.

Ferner wird bei diesem Verfahren nach der Messung des Laststromes $I_L$ noch der Kreisstrom $I_C$ ermittelt, wie ebenfalls bereits erläutert.

Schließlich wird beim erfindungsgemäßen Verfahren die Berechnung des jeweiligen Schaltstromes für den abschaltenden Kontakt, nachfolgend die Ermittlung der Abbrandraten und wiederum nachfolgend die Kumulierung des jeweiligen Volumenabbrandes GA nicht nur getrennt nach der Schaltrichtung "höher" oder "tiefer" durchgeführt. Vielmehr erfolgt innerhalb dieser Verfahrensschritte, die abhängig von der Schaltrichtung sind, noch einmal eine weitere Trennung der Verfahrensschritte danach, ob von einer nicht brückenden Stellung auf eine brückende Stellung umgeschaltet wird oder nicht. Je nach Situation müssen die Schaltströme der jeweils geltenden Formeln entsprechend ermittelt werden.

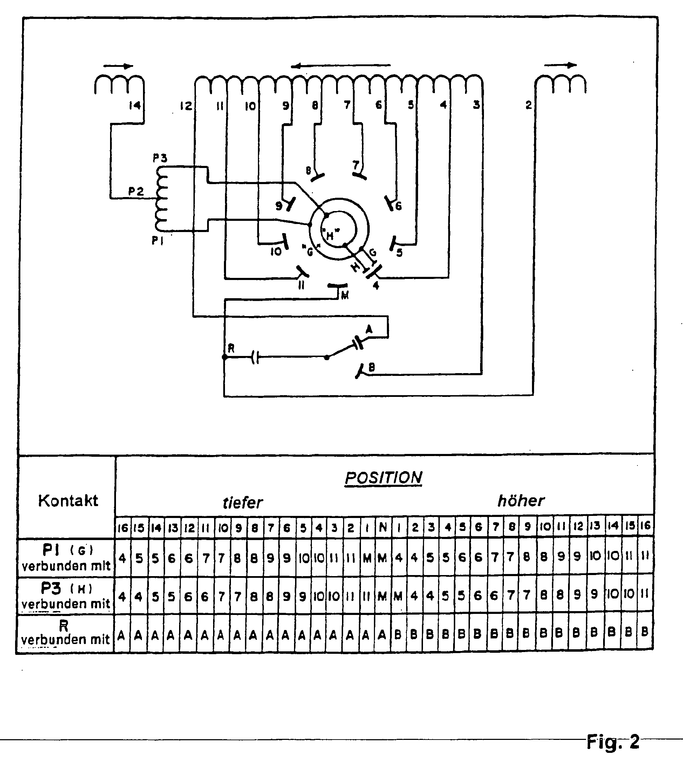

Für dieses Verfahren ist auf besonders vorteilhafte Weise eine vorab nicht flüchtig gespeicherte Zuordnungstabelle (sog. "look-up table") verwendbar, um auf einfache Weise die bei der jeweiligen Schaltung beteiligten geschalteten Festkontakte zu ermitteln. Ein Beispiel einer solchen Zuordnungstabelle zur Durchführung des zweiten Verfahrens gemäß den Figuren 1a bis 1d ist in der separaten Figur 2 gezeigt.

**Patentansprüche**

**1.** Verfahren zur Überwachung des Kontaktabbrandes bei Stufenschaltern mit einer symmetrisch zweigeteilten Überschaltreaktanz, **gekennzeichnet durch** die folgenden Verfahrensschritte:

• Permanentes Speichern der Werte für die Nenn-Stufenspannung ($U_S$) jeder möglichen Schaltung, d. h. Stufe, der Grenzwerte für den zulässigen Kontaktabbrand des Schaltkontaktes sowie der Widerstandskontakte sowie der stufenschalterspezifischen Kenngrößen $a_{SK}$, $a_{FK}$, b, $s_{SK}$ und $s_{FK}$
• Berechnung der ohmschen Komponente R sowie der induktiven Komponente X der Überschaltreaktanz
• Ermittlung der aktuellen Stellung n des Stufenschalters
• Messung des Laststromes ($I_L$) bei jeder Umschaltung, d. h. Betätigung des Stufenschalters
• Berechnung des Kreisstromes $I_C$ als Teilbetrag des Laststromes $I_L$
• Ermittlung der Schaltrichtung "höher" oder "tiefer" der jeweiligen Umschaltung
• schaltrichtungsabhängige Ermittlung des geschalteten, abbrandbehafteten Festkontaktes
• Ermittlung, ob von einer nicht-brückenden auf eine brückende Position umgeschaltet wird oder nicht
• Berechnung des Schaltstromes der abschaltenden Kontakte jeweils mittels der Beziehungen

$$I_{SK} = \frac{I_L}{2}$$

für eine Schaltung von nicht-brückend nach brückend und

$$I_{SK} = \frac{I_L}{2} \cdot (R - jX) - jI_C \quad \text{bzw.} \quad I_{SK} = \frac{I_L}{2} \cdot (R - jX) + jI_C$$

im jeweils anderen Fall
• schaltrichtungsabhängige Berechnung der jeweiligen Abbrandraten des Schaltkontaktes ($A_{SK}$) und des abschaltenden Festkontaktes ($A_{FK}$) nach der Beziehung

$$A_{SK} = a_{SK} \cdot I_{SK}{}^b \cdot s_{SK}$$

$$A_{FK} = a_{FK} \cdot I_{SK}{}^b \cdot s_{FK}$$

• Aufsummierung der jeweiligen Abbrandraten ($A_{SK}$, $A_{FK}$) zum jeweiligen Gesamtvolumenabbrand ($GA_H$, $GA_G$, $GA^{re}_{FK-m}$, $GA^{li}_{FK-m}$), nichtflüchtige Speicherung aller aufsummierten Gesamtvolumenabbrände und Vergleich dieser Werte mit den entsprechenden permanent gespeicherten Grenzwerten
• Generierung von Meldungen beim Überschreiten der jeweiligen Grenzwerte oder prozentualer Grenzen davon.

**Claims**

1. Method of monitoring contact erosion in tap changers with a transition reactance symmetrically divided in two, **characterised by** the following method steps:

   - permanent storage of the values for the nominal tap voltage ($U_S$) of each possible switching, i.e. step, the limit values for the permissible contact erosion of the switch contact and the resistance contacts, and the characteristic magnitudes $a_{SK}$, $a_{FK}$, b, $s_{SK}$ and $s_{FK}$ specific to the tap changer,
   - calculation of the resistive component R and the inductive component X of the transition reactance,
   - determination of the instantaneous setting n of the tap changer,
   - measurement of the load current ($I_L$) in each switching over, i.e. actuation of the tap changer,
   - calculation of the circuit current $I_C$ as part amount of the load current $I_L$,
   - determination of the switching direction 'higher' or 'lower' of the respective switching over,
   - determination, depending on switching direction, of the switched fixed contact liable to erosion,
   - determining whether or not there is switching over from a non-bridging position to a bridging position,
   - calculation of the switching current of the contact, which is being switched from, respectively by means of the equations

$$I_{SK} = \frac{I_L}{2}$$

for a switching from non-bridging to bridging and

$$I_{SK} = \frac{I_L}{2} \cdot (R - jX) - jIc$$

or

$$I_{SK} = \frac{I_L}{2} \cdot (R - jX) + jIc$$

in the respective other case
- calculation, depending on switching direction, of the respective rates of erosion of the switching contact ($A_{SK}$) and of the fixed contact ($A_{FK}$), which is being switched from, according to the equation

$$A_{SK} = a_{SK} \cdot I_{SK}{}^b \cdot s_{SK}$$

$$A_{FK} = a_{FK} \cdot I_{SK}{}^b \cdot s_{FK}$$

- summation of the respective rates of erosion ($A_{SK}$, $A_{FK}$) relative to the respective total volume erosion ($GA_H$, $GA_G$, $GN^{re}_{FK-m}$, $GA^{li}_{FK-m}$), non-volatile storage of all summated total volume erosions and comparison of these values with the corresponding permanently stored limit values, and
- generation of reports in the case of exceeding of the respective limit values or percentage limits thereof.

**Revendications**

1. Procédé de surveillance de l'usure des contacts pour des commutateurs à gradins dotés d'une réactance de passage divisée symétriquement en deux,
**caractérisé par**
les étapes de procédé suivantes :

- stockage permanent des valeurs de la tension de gradin nominale (Us) de chaque commutation possible, c'est-à-dire gradin, des valeurs limite de l'usure autorisée du contact de commutation et des contacts de résistance ainsi que des grandeurs caractéristiques $a_{SK}$, $a_{FK}$, b, $s_{SK}$ et $s_{FK}$,
- calcul de la composante ohmique R ainsi que de la composante inductive X de la réactance de passage,
- détermination de la position actuelle n du commutateur à gradins,
- mesure du courant de charge ($I_L$) a chaque commutation, c'est-à-dire à chaque actionnement du commutateur à gradins,
- calcul du courant circulaire $I_C$ en tant que valeur partielle du courant de charge $I_L$,
- détermination de la direction de commutation « vers le haut » ou « vers le bas » de la commutation respective
- détermination, en fonction de la direction de commutation, du contact fixe commuté ayant subi une usure,
- détermination si la commutation s'est effectuée d'une position de non-pontage à une position de pontage ou non,

- calcul du courant de commutation des contacts de désactivation, au moyen des relations :

$$I_{SK} = \frac{I_L}{2}$$

pour une commutation de la position de non-pontage à la position de pontage, et respectivement

$$I_{SK} = \frac{I_L}{2} \cdot (R - jX) - jI_C \quad \text{ou} \quad I_{SK} = \frac{I_L}{2} \cdot (R - jX) + jI_C$$

dans chaque autre cas :

- calcul, en fonction de la direction de commutation, des taux d'usure respectifs du contact de commutation ($A_{SK}$) et du contact fixe de désactivation ($A_{FK}$) selon les relations :

$$A_{SK} = a_{SK} \cdot I_{SK}^{b} \cdot s_{SK}$$

$$A_{FK} = a_{FK} \cdot I_{SK}^{b} \cdot s_{FK}$$

- addition des taux d'usure respectifs ($A_{SK}$, $A_{FK}$) avec l'usure volumique totale ($GA_H$, $GA_G$, $GA^{re}_{FK-m}$, $GA^{li}_{FK-m}$), stockage non-volatil de toutes les usures volumiques totales ajoutées et comparaison de ces valeurs avec les valeurs limite stockées de façon permanente, et
- génération de messages lors du dépassement des valeurs limite respectives ou de limites en pourcentage de celles-ci.

START

Eingabe und nichtflüchtige Speicherung der benötigten Stufenschalter- und Abbrandparameter, der Abbrandgrenzwerte sowie der Nenn-Stufenspannung

Variablen berechnen:

$$R = \frac{pf}{100}$$

$$X = \sqrt{1 - R^2}$$

Schaltungszähler    z = 0

Stellungsmelde-einrichtung → aktuelle Stufenschalterstellung n ermitteln

(n=1..33)

n gerade    : bridging to non-bridging
n ungerade: non-bridging to bridging

Motorantrieb — Schaltimpuls → "höher" oder "tiefer"

Schaltungszähler inkrementieren   z = z+1

Laststrom IL messen

Variable berechnen:

$$I_C = I_L \cdot \frac{P.A.}{100}$$

Schaltung erfolgte in welcher Richtung ?

höher    tiefer

a          b          c

**Fig. 1a**

8

(a)

geschalteten Festkontakt m
per *look-up table* bestimmen:
m = f (n, Schaltrichtung)

**Subroutine 1:**
Berechnung der
Schaltströme,
Abbrandraten und
Volumenabbrand für
abschaltenden Kontakt;
Speicherung der
Rechenwerte

n=n+1

(b)

geschalteten Festkontakt m
per *look-up table* bestimmen:
m = f (n, Schaltrichtung)

**Subroutine 2:**
Berechnung der
Schaltströme,
Abbrandraten und
Volumenabbrand für
abschaltenden Kontakt;
Speicherung der
Rechenwerte

n=n-1

(c)

Stufenschalterstellung aktualisieren

x %
des zulässigen
Kontaktabbrandes
erreicht ?

ja

nein

Warnmeldung ausgeben
und / oder
STOP

**Fig. 1b**

9

**Subroutine 1**

non-bridging to bridging ?

— neln —                    — ja —

Schaltstrom für abschaltenden
Kontakt berechnen:

$$I_{SK} = \frac{I_L}{2} \cdot (R - jX) - j I_C$$

Schaltstrom für abschaltenden
Kontakt berechnen:

$$I_{SK} = \frac{I_L}{2}$$

Abbrandraten berechnen:

$$A_{SK} = a_{SK} \cdot I_{SK}^{\ b} \cdot s_{SK}$$

$$A_{FK} = a_{FK} \cdot I_{SK}^{\ b} \cdot s_{FK}$$

Abbrandraten berechnen:

$$A_{SK} = a_{SK} \cdot I_{SK}^{\ b} \cdot s_{SK}$$

$$A_{FK} = a_{FK} \cdot I_{SK}^{\ b} \cdot s_{FK}$$

Volumenabbrand kumulieren:

$$GA_H = GA_H + A_{SK}$$

$$GA_{FK-m}^{re} = GA_{FK-m}^{re} + A_{FK}$$

Volumenabbrand kumulieren:

$$GA_G = GA_G + A_{SK}$$

$$GA_{FK-m}^{re} = GA_{FK-m}^{re} + A_{FK}$$

nichtflüchtige Speicherung
der Rechenwerte GA

nichtflüchtige Speicherung
der Rechenwerte GA

**Fig. 1c**

10

Subroutine 2

non-bridging to bridging ?

nein — ja

**Schaltstrom für abschaltenden Kontakt berechnen:**
$$I_{SK} = \frac{I_L}{2} \cdot (R - jX) + jI_C$$

**Schaltstrom für abschaltenden Kontakt berechnen:**
$$I_{SK} = \frac{I_L}{2}$$

**Abbrandraten berechnen:**
$$A_{SK} = a_{SK} \cdot I_{SK}{}^b \cdot s_{SK}$$
$$A_{FK} = a_{FK} \cdot I_{SK}{}^b \cdot s_{FK}$$

**Abbrandraten berechnen:**
$$A_{SK} = a_{SK} \cdot I_{SK}{}^b \cdot s_{SK}$$
$$A_{FK} = a_{FK} \cdot I_{SK}{}^b \cdot s_{FK}$$

**Volumenabbrand kumulieren:**
$$GA_G = GA_G + A_{SK}$$
$$GA_{FK-m}^{li} = GA_{FK-m}^{li} + A_{FK}$$

**Volumenabbrand kumulieren:**
$$GA_H = GA_H + A_{SK}$$
$$GA_{FK-m}^{li} = GA_{FK-m}^{li} + A_{FK}$$

nichtflüchtige Speicherung der Rechenwerte GA

nichtflüchtige Speicherung der Rechenwerte GA

**Fig. 1d**

| Kontakt | POSITION | | | | | | | | | | | | | | | | | | | | | | | | | | | | | | | | |
|---|---|---|---|---|---|---|---|---|---|---|---|---|---|---|---|---|---|---|---|---|---|---|---|---|---|---|---|---|---|---|---|---|---|
| | tiefer | | | | | | | | | | | | | | | | | höher | | | | | | | | | | | | | | | |
| | 16 | 15 | 14 | 13 | 12 | 11 | 10 | 9 | 8 | 7 | 6 | 5 | 4 | 3 | 2 | 1 | N | 1 | 2 | 3 | 4 | 5 | 6 | 7 | 8 | 9 | 10 | 11 | 12 | 13 | 14 | 15 | 16 |
| **P1 (G)** verbunden mit | 4 | 5 | 5 | 6 | 6 | 7 | 7 | 8 | 8 | 9 | 9 | 10 | 10 | 11 | 11 | M | M | 4 | 4 | 5 | 5 | 6 | 6 | 7 | 7 | 8 | 8 | 9 | 9 | 10 | 10 | 11 | 11 |
| **P3 (H)** verbunden mit | 4 | 4 | 5 | 5 | 6 | 6 | 7 | 7 | 8 | 8 | 9 | 9 | 10 | 10 | 11 | 11 | M | M | 4 | 4 | 5 | 5 | 6 | 6 | 7 | 7 | 8 | 8 | 9 | 9 | 10 | 10 | 11 |
| **R** verbunden mit | A | A | A | A | A | A | A | A | A | A | A | A | A | A | A | A | A | B | B | B | B | B | B | B | B | B | B | B | B | B | B | B | B |

Fig. 2

-Stand der Technik-

**Fig. 3**

**EP 1 682 911 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10003918 C1